# EUROPÄISCHE PATENTANMELDUNG

(11) **EP 4 683 224 A1**
(43) Veröffentlichungstag der Anmeldung: **21.01.2026**
(21) Anmeldenummer: 25190049.4
(22) Anmeldetag: 17.07.2025
(51) Int. Cl.: H03K 17/081, H02H 3/20, B60R 16/00, H02H 1/00, H02H 7/00, H02H 3/12

(54) **VORRICHTUNG ZUM SCHUTZ EINER AN EIN STROMVERSORGUNGSNETZ ANGESCHLOSSENEN SCHALTUNG VOR ÜBERSPANNUNGEN**

(30) Priorität: 18.07.2024 DE 102024120342
(71) Anmelder: Turck Holding GmbH, 58553 Halver (DE)
(72) Erfinder: Riese, Thomas, 42653 Solingen (DE)
(74) Vertreter: DTS Patent- und Rechtsanwälte PartmbB

(57) **Zusammenfassung**

Die vorliegende Erfindung betrifft eine Vorrichtung (100) zum Schutz einer an ein Stromversorgungsnetz, insbesondere an ein Stromversorgungsnetz eines Fahrzeugs, angeschlossenen Schaltung vor Überspannungen; umfassend einen elektrischen Eingang (125) zum Anlegen einer Eingangsspannung; einen elektrischen Ausgang (130) zum Bereitstellen einer elektrischen Ausgangsspannung an das Stromversorgungsnetz beziehungsweise an die angeschlossene Schaltung; und eine elektrische Schutzschaltung mit einem Erkennungsabschnitt (135), einem Halbleiterschalter (T109) und einem Begrenzungsabschnitt (140); wobei der Halbleiterschalter (T109) zwischen dem elektrischen Eingang (125) und dem elektrischen Ausgang (130) angeordnet und so ansteuerbar ist, dass das Ausgeben der Ausgangsspannung am elektrischen Ausgang (130) unterbrochen werden kann; wobei der Erkennungsabschnitt (135) dazu eingerichtet ist, beim Erreichen eines Schwellenwerts der Eingangsspannung den Halbleiterschalter (T109) mittels einer Ansteuerspannung so anzusteuern, dass die Ausgabe der Ausgangsspannung unterbrochen wird; wobei der Erkennungsabschnitt (135) ein Spannungsschwellen-Detektorelement (D103) aufweist, beispielsweise eine Zenerdiode (D103); und wobei der Begrenzungsabschnitt (140) dazu eingerichtet ist, bei unterbrochener Ausgangsspannung die Ansteuerspannung für den Halbleiterschalter (T109) zu begrenzen; wobei der Erkennungsabschnitt (135) eine den Strom einprägende Komponente (T102, T104) zum Begrenzen eines durch das Spannungsschwellen-Detektorelement (D103) fließenden Stroms umfasst.

Fig. 1

## Beschreibung

Die vorliegende Erfindung betrifft eine Vorrichtung zum Schutz einer an ein Stromversorgungsnetz, insbesondere an ein Stromversorgungsnetz eines Fahrzeugs, angeschlossenen Schaltung vor Überspannungen. Beispielsweise kann die Vorrichtung eingerichtet sein zum Schutz einer Schaltung oder eines Geräts, das an ein Stromversorgungsnetz eines Fahrzeugs mit einer Lichtmaschine oder einem elektrischen Generator angeschlossen ist.

Die Erfindung liegt damit auf dem Gebiet der Schaltungstechnik, der Schutzschaltungen und insbesondere der Vermeidung von Schäden durch Überspannungen in Fahrzeugnetzen.

In verschiedenen Einsatzszenarien, beispielsweise in Fahrzeugen mit einer Lichtmaschine, können durch Schwankungen des Laststroms hohe Überspannungen auftreten. Dazu kommt es insbesondere dann, wenn die Verbindung zur Fahrzeugbatterie relativ hochohmig ist oder ganz unterbrochen wird. Durch die Induktivität der Lichtmaschine kann es bei schnellen Änderungen des Laststroms zu hohen Induktionsspannungen kommen, die als Spannungsspitzen abgegeben werden. Hierbei wird die im Magnetfeld der Lichtmaschine gespeicherte Energie ganz oder teilweise an das Fahrzeugnetz in Form einer Spannungsüberhöhung abgegeben. Der Effekt ist allgemein als "Lastabwurf" (englisch: "load dump") bekannt.

Ein weiterer Einfluss entsteht durch die endliche Geschwindigkeit des Ladereglers und die Induktivität des Erregerkreises, wodurch sich der Erregerstrom nur mit einer endlichen Geschwindigkeit ändern kann. Dies führt bei Wegfall des Laststroms ebenfalls zu einer Spannungsüberhöhung.

Der Lastabwurf kann durch die Überspannung erhebliche Schäden an Schaltungen beziehungsweise Geräten verursachen, die an ein Fahrzeugnetz angeschlossen sind. Dies können beispielsweise Sensoren oder Aktoren sein.

Es wurden verschiedene Strategien vorgeschlagen, wie elektrische Geräte vor solchen Spannungsspitzen geschützt werden können. Die DE 10 2017 123 484 A1 beschreibt eine Überspannungsschutzschaltung, aus der US 2002/0109952 A1 ist eine Hochspannungsschutzschaltung für Kraftfahrzeuge bekannt, die eine elektrische Last bei Überspannungsbedingungen vor Beschädigung und/oder Stromunterbrechung schützt, und die US 2003/0223169 A1 beschreibt eine Überspannungsschutzschaltung und eine Reihenschlussschaltung zum Schutz einer elektrischen Last vor Schäden durch Überspannung. Auch die US 2004/0061379 A1 schließlich beschreibt ein System zum Schutz eines Fahrzeugsystem vor einem Lastabwurf. In der US 2014/0002941 A1 wird ein Überspannungsschutz mit einem vorgespannten Riegel beschrieben.

Es kann eine Schutzschaltung vorgesehen sein, bei der mittels einer Spannungsbegrenzung die nachfolgenden Schaltungsteile geschützt werden. Dabei kann es zu Schwierigkeiten kommen, wenn die Schaltung nur begrenzt belastbar ist gegenüber in schneller Folge wiederholten Überspannungsimpulsen.

Ferner ist es bekannt, eine Spannungsbegrenzung durch Transildioden beziehungsweise Zener-Dioden im Gleichrichter der Lichtmaschine zu integrieren. Dies ist typischerweise auf etwa 80 V Spannung begrenzt, sodass dieser Schutz alleine ohne weitere Maßnahmen nicht ausreicht, um einen umfassenden Schutz zu gewährleisten.

Typischerweise wird bei bekannten Systemen im Fall einer Überspannung die Spannungsversorgung des zu schützenden Geräts unterbrochen und ferner kann vorgesehen sein, dass ein Strom über einen Widerstand fließt, durch dessen Erwärmung es zur Dissipation der Energie der Spannungsspitze kommt. Dieses Vorgehen führt zu erheblichen Belastungen der Bauteile, sodass die Schaltung nur begrenzt haltbar ist, insbesondere bei häufigen und/oder lang andauernden Überspannungsimpulsen.

Beispielsweise kann das Bordnetz kurzgeschlossen werden (Crowbar), wobei es zu hohen Stromstärken kommt und ebenso hohe lokale Verlustleistungen auftreten. Ferner kann die Verbindung unterbrochen werden, wobei lokal keine übergroßen Verlustleistungen auftreten und kein Strom fließt, sondern die Energie der Überspannung an anderer Stelle im Bordnetz verbleibt, etwa in Transildioden der Lichtmaschine.

Es ist die Aufgabe der vorliegenden Erfindung, eine Vorrichtung der eingangs genannten Art bereitzustellen, die einen zuverlässigen und robusten Schutz von elektrischen Komponenten gegen Überspannungsimpulse bietet und die dabei langlebig und flexibel einsetzbar ist.

Diese Aufgabe wird erfindungsgemäß gelöst durch eine Vorrichtung mit den Merkmalen des Anspruchs 1. Vorteilhafte Ausgestaltungen sind in den Unteransprüchen angegeben.

Danach wird die Aufgabe gelöst durch eine Vorrichtung zum Schutz einer an ein Stromversorgungsnetz, insbesondere an ein Stromversorgungsnetz eines Fahrzeugs, angeschlossenen Schaltung vor Überspannungen. Die Vorrichtung umfasst einen elektrischen Eingang zum Anlegen einer Eingangsspannung, beispielsweise zum Anschluss an die Lichtmaschine des Fahrzeugs. Sie umfasst ferner einen elektrischen Ausgang zum Ausgeben einer elektrischen Ausgangsspannung an das Stromversorgungsnetz sowie gegebenenfalls an eine an das Stromversorgungsnetz angeschlossene Schaltung beziehungsweise einen elektrischen Verbraucher. Sie umfasst zudem eine elektrische Schutzschaltung mit einem Erkennungsabschnitt, einem Halbleiterschalter und einem Begrenzungsabschnitt. Dabei ist der Halbleiterschalter zwischen dem elektrischen Eingang und dem elektrischen Ausgang angeordnet und so ansteuerbar, dass das Ausgeben der Ausgangsspannung am elektrischen Ausgang unterbrochen werden kann beziehungsweise unterbrochen wird. Dabei ist der Erkennungsabschnitt dazu eingerichtet, beim Erreichen oder Überschreiten eines Schwellenwerts der Eingangsspannung den Halbleiterschalter mittels einer Ansteuerspannung so anzusteuern, dass die Ausgabe der Ausgangsspannung unterbrochen wird beziehungsweise dass die Ausgabe einer elektrischen Leistung über den elektrischen Ausgang unterbrochen wird. Dabei weist der Erkennungsabschnitt ein Spannungsschwellen-Detektorelement auf, beispielsweise eine Zenerdiode. Dabei ist ferner der Begrenzungsabschnitt dazu eingerichtet, bei unterbrochener Ausgangsspannung die Ansteuerspannung für den Halbleiterschalter zu begrenzen, insbesondere auf einen vorgegebenen/bestimmten maximalen Wert. Dabei umfasst der Erkennungsabschnitt eine den Strom einprägende Komponente zum Begrenzen eines durch das Spannungsschwellen-Detektorelement fließenden Stroms.

Dadurch wird vorteilhafterweise verhindert, dass bei größeren Überspannungen der Halbleiterschalter durch eine entsprechend hohe auf ihn wirkende Ansteuerspannung beschädigt oder zerstört wird.

Die Vorrichtung kann ferner vorteilhafterweise mit einfachen Mitteln sehr belastbar ausgebildet werden, was die Widerstandsfähigkeit gegen praktisch beliebig zeitlich gehäufte und lange Überspannungsimpulse angeht.

Nachfolgend werden unter zu schützenden "Schaltungen" insbesondere als Schaltungen, Komponenten und/oder Geräte verstanden, welche an das Stromversorgungsnetz angeschlossen sind.

Bei der Vorrichtung stellt insbesondere der Erkennungsabschnitt die Ansteuerspannung bereit, durch welche der Halbleiterschalter angesteuert wird.

Als "Stromsenke" wird insbesondere eine Schaltung verstanden, die dazu dient, im Fall einer Überspannung den Strom in den Bauteilen zu begrenzen und so sicherzustellen, dass kein für die Vorrichtung schädlicher Strom fließt. Insbesondere wird vermieden, dass die auftretende Stromstärke einen vorgegebenen Wert übersteigt. Insbesondere werden dadurch unerwartet hohe Ströme innerhalb der Vorrichtung vermieden.

Eine Stromsenke kann etwa mittels einer Kombination eines Transistors, eines Widerstands und einer Referenzspannung realisiert werden. Zum Beispiel kann ein Transistor verwendet werden, dessen Kollektor mit dem Ausgang der zu begrenzenden Spannung verbunden ist, während der Emitter mit der Masse verbunden ist. Ein mit dem Kollektor oder zwischen Basis und Emitter in Serie geschalteter Widerstand kann den Strom durch die Basis des Transistors kontrollieren.

Eine stabile Spannungsreferenz kann etwa durch eine Zenerdiode bereitgestellt werden, um die Basis-Emitter-Spannung des Transistors zu steuern.

Wenn die Eingangsspannung einen festgelegten Wert überschreitet, beginnt die Zenerdiode zu leiten. Die Stromsenke begrenzt dabei den Strom durch die Zenerdiode auf einen zulässigen Wert.

Die Zenerdiode in Verbindung mit der Stromsenke überwacht die Eingangsspannung und begrenzt den Stromfluss, wenn die Spannung einen bestimmten Wert überschreitet; beispielsweise wird dazu ein Transistor in einem Regelkreis eingesetzt.

Bei einer Ausbildung umfasst der Erkennungsabschnitt eine Zener-Diode, die dazu eingerichtet ist, dass sie bis zum Erreichen des Schwellenwerts der Eingangsspannung gegen einen Stromfluss gesperrt ist.

Der Erkennungsabschnitt kann dadurch vorteilhafterweise besonders einfach und mit leicht verfügbaren Bauteilen gebildet werden. Insbesondere fließt oberhalb des Schwellenwerts der Eingangsspannung Strom, sodass die Zener-Diode als Sensorelement für das Erreichen oder Überschreiten des Schwellenwerts der Eingangsspannung dient.

Bei einer weiteren Ausbildung ist der Halbleiterschalter als P-Kanal-Feldeffekttransistor, insbesondere als P-Kanal-MOSFET, ausgebildet.

Bei einer Weiterbildung ist der Gate-Anschluss des Halbleiterschalters, insbesondere des als P-Kanal-Feldeffekttransistor ausgebildeten Halbleiterschalters, über einen Transistor mit dem Erkennungsabschnitt verbunden und wird über diesen angesteuert.

Geeignete P-Kanal-MOSFET, die beispielsweise für eine vorgeschriebene maximale Prüfspannung von 207 V oder für andere Spannungen von über 200 V geeignet sind, sind allerdings auf dem Markt schlecht verfügbar. Durch eine Schaltungsvariante kann die Verwendung von N-Kanal MOSFET ermöglicht werden. Dadurch ergibt sich vorteilhafterweise eine größere Auswahl an geeigneten Bauteilen.

Bei einer weiteren Ausbildung ist der Halbleiterschalter als N-Kanal-FET, insbesondere als N-Kanal-MOSFET, ausgebildet. Diese Bauteile sind vorteilhafterweise mit besserer Spannungsfestigkeit verfügbar.

Gegenüber einer Schaltung der Vorrichtung für N-Kanal-Transistoren erfolgt für einen P-Kanal-FET die Ansteuerung mit negativer Gate-Spannung gegenüber der Source-Spannung. Sofern diese Möglichkeit nicht unmittelbar verfügbar ist, kann eine alternative Ansteuerung des Halbleiterschalters implementiert werden.

Bei einer weiteren Ausbildung ist der Erkennungsabschnitt so mit einem galvanischen Trennelement verbunden, dass beim Überschreiten des Schwellenwerts der Eingangsspannung der Halbleiterschalter über das galvanische Trennelement so angesteuert wird, dass die Ausgabe der Ausgangsspannung unterbrochen wird. Diese Ausbildung kann insbesondere für einen Halbleiterschalter mit einem N-Kanal-FET verwendet werden.

Bei einer Ausbildung ist dabei die den Strom einprägende Komponente des Erkennungsabschnitts dazu ausgebildet, den durch das galvanische Trennelement fließenden Strom zu begrenzen.

Bei einer Ausbildung umfasst das galvanische Trennelement einen Optokoppler, insbesondere mit einer Solarzelle. Das galvanische Trennelement kann beispielsweise als Optokoppler mit einer Leuchtdiode und einer Solarzelle ausgebildet sein. Vorteilhafterweise kann der Optokoppler dabei die Funktion erfüllen, die Ansteuerspannung für den Halbleiterschalter zu begrenzen.

Bei einer weiteren Ausbildung ist die Vorrichtung zum Schutz des Stromversorgungsnetzes bei einem Lastabwurf (englisch: *load dump*) ausgebildet, insbesondere bei einer an den elektrischen Eingang angeschlossenen Lichtmaschine eines Fahrzeugs. Insbesondere ist dabei eine entsprechende Dimensionierung der Teile vorgesehen, sodass der Schutz der Schaltung vor Überspannungsimpulsen der Eingangsspannung erfüllt werden kann.

Weitere Einzelheiten und Vorteile der Erfindung sollen nun anhand eines in den Zeichnungen dargestellten Ausführungsbeispiels näher erläutert werden.

Es zeigen:
Fig. 1 ein schematisches Diagramm eines ersten Ausführungsbeispiels der Vorrichtung mit einem P-Kanal-Feldeffekttransistor; und
Fig. 2 ein schematisches Diagramm eines zweiten Ausführungsbeispiels der Vorrichtung mit einem N-Kanal-Feldeffekttransistor.

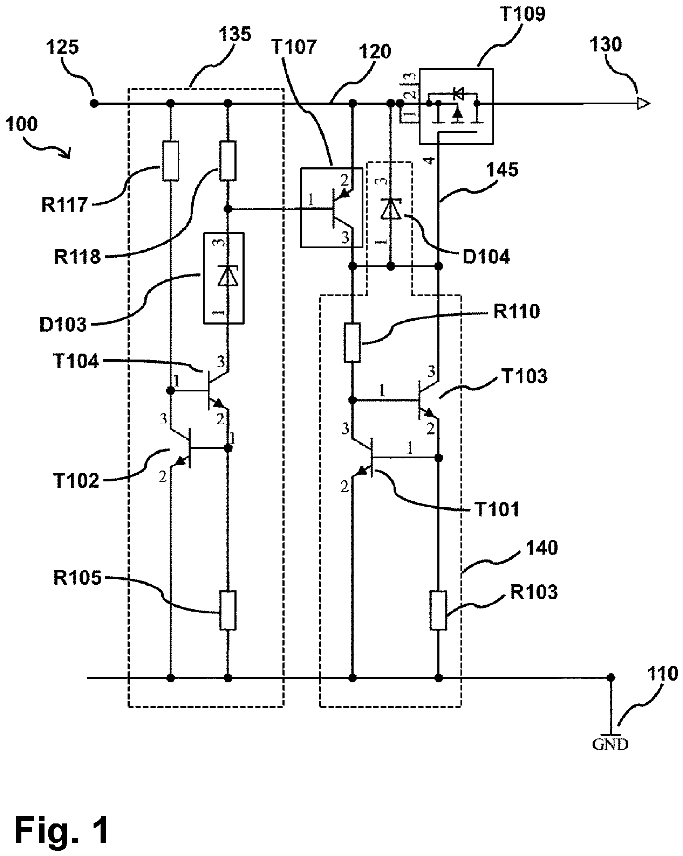

Mit Bezug zu Fig. 1 wird ein schematisches Diagramm eines ersten Ausführungsbeispiels der Vorrichtung mit einem P-Kanal-Feldeffekttransistor erläutert.

Die Vorrichtung 100 des ersten Ausführungsbeispiels weist einen elektrischen Eingang 125 auf, an den eine Eingangsspannung angelegt werden kann. Bei dem ersten Ausführungsbeispiel der Vorrichtung 100 ist der elektrische Eingang 125 mit einer Lichtmaschine eines Fahrzeugs verbunden.

Die Vorrichtung 100 weist ferner einen elektrischen Ausgang 130 auf, über den eine elektrische Ausgangsspannung ausgegeben werden kann. Bei dem ersten Ausführungsbeispiel ist eine elektrische Schaltung als Verbraucher an den elektrischen Ausgang 130 angeschlossen, etwa ein Sensor. Ein Beispiel eines angeschlossenen Sensors kann ein Radarsensor eines Fahrzeugs sein.

Von dem elektrischen Eingang 125 zum elektrischen Ausgang 130 führt eine Verbindungsleitung 120.

Die Vorrichtung 100 weist zudem einen Anschluss 110 zu einem Massepotential (englisch *ground,* GND) auf.

Die Vorrichtung 100 umfasst eine elektrische Schutzschaltung mit einem Erkennungsabschnitt 135 und einem Begrenzungsabschnitt 140, welche an die Verbindungsleitung 120 angeschossen sind, sowie einen in der Verbindungsleitung 120 angeordneten Halbleiterschalter T109.

Der Halbleiterschalter T109, der bei dem ersten Ausführungsbeispiel als P-Kanal-FET T109 ausgebildet ist, ist zwischen dem elektrischen Eingang 125 und dem elektrischen Ausgang 130 angeordnet, sodass durch ihn der Stromfluss zu der an den elektrischen Ausgang 130 angeschlossenen Schaltung geöffnet oder geschlossen werden kann.

Der Halbleiterschalter T109 kann insofern mit einem Ventil verglichen werden, das den Fluss des Stroms von dem elektrischen Eingang 125 zum elektrischen Ausgang 130 öffnen und schließen kann.

Der Erkennungsabschnitt 135 ist dazu ausgebildet, den Halbleiterschalter T109 über eine Ansteuerspannung anzusteuern. Der Erkennungsabschnitt 135 ist bei dem ersten Ausführungsbeispiel dazu ausgebildet, eine Überspannung beim Überschreiten von beispielsweise 18 V oder 47 V zu erkennen und in diesem Fall die Ansteuerspannung so an den Halbleiterschalter T109 auszugeben, dass die zu schützende Schaltung von der Eingangsspannung getrennt wird.

Bei dem ersten Ausführungsbeispiel umfasst der Erkennungsabschnitt 135 in einem ersten Zweig zwischen dem elektrischen Eingang 125 und dem Anschluss 110 zum Massepotential einen ersten Widerstand R117 und einen ersten stromabwärts davon geschalteten Transistor T102. Parallel dazu sind in einem zweiten Zweig ein zweiter Widerstand R118, stromabwärts davon ein zweiter Transistor T104 und wiederum stromabwärts davon ein dritter Widerstand R105 geschaltet.

Der erste und zweite Zweig des Erkennungsabschnitts 135 sind zwischen dem elektrischen Eingang 125 und dem Halbleiterschalter T109 angeschlossen.

Die Basis des im zweiten Zweig angeordneten zweiten Transistors T104 ist zwischen dem ersten Widerstand R117 und dem ersten Transistor T102 mit dem ersten Zweig verbunden. Hingegen ist die Basis des erstes Transistors T102 zwischen dem zweiten Transistor T104 und dem dritten Widerstand R105 mit dem zweiten Zweig verbunden.

In dem zweiten Zweig ist ferner zwischen dem zweiten Widerstand R118 und dem zweiten Transistor T104 eine Zener-Diode D103 in Sperrrichtung von dem elektrischen Eingang 125 zum Anschluss 110 des Massepotentials angeordnet. Das heißt, die Zener-Diode D103 sperrt gegen einen Stromfluss, bis die am elektrischen Eingang 125 anliegende Eingangsspannung einen Schwellenwert erreicht oder überschreitet, die bei dem ersten Ausführungsbeispiel bei beispielsweise 18 V oder 47 V liegt.

Zwischen den Anschlüssen des ersten und zweiten Zweiges des Erkennungsabschnitts 135 und dem Halbleiterschalter T109 sind zwei weitere Anschlüsse für einen ersten und einen zweiten Zweig des Begrenzungsabschnitts 140 angeordnet.

Der Begrenzungsabschnitt 140 ist dabei ähnlich aufgebaut wie der Erkennungsabschnitt 135. In dem ersten Zweig des Begrenzungsabschnitts 140 sind ein vierter Widerstand R110 und ein dritter Transistor T101 angeordnet. In dem zweiten Zweig des Begrenzungsabschnitts 140 sind umgekehrt ein vierter Transistor T103 und stromabwärts davon ein fünfter Widerstand R103 angeordnet. Die Basis des vierten Transistors T103 ist dabei zwischen dem vierten Widerstand R110 und dem dritten Transistor T101 mit dem ersten Zweig verbunden. Umgekehrt ist die Basis des dritten Transistors T101 stromabwärts von dem vierten Transistor T103 mit dem zweiten Zweig verbunden.

Der Begrenzungsabschnitt 140 ist über zwei weitere Leitungen mit der Verbindungsleitung 120 verbunden. Dabei ist in einer dieser Leitungen ein fünfter Transistor T107 angeordnet, dessen Basis mit dem zweiten Zweig des Erkennungsabschnitts 135 zwischen dem zweiten Widerstand R118 und der Zener-Diode D103 verbunden ist. Der Begrenzungsabschnitt 140 umfasst ferner eine zweite Zener-Diode D104, die in der anderen dieser Leitungen von der Verbindungsleitung 102 ausgehend in Sperrrichtung angeordnet ist.

Auch die zweite Zener-Diode D104 ist bei dem ersten Ausführungsbeispiel so ausgebildet, dass sie bei Erreichen beziehungsweise Überschreiten eines Schwellenwerts, beispielsweise von 18 V oder 47 V, in Sperrrichtung leitend wird.

Über eine Ansteuerungsleitung 145 ist der Begrenzungsabschnitt 140 ferner mit dem Gate-Anschluss des Halbleiterschalters T109 verbunden. Hier kann mithin die Ansteuerungsspannung an den Gate-Anschluss des Halbleiterschalters T109 angelegt werden, um über diesen die elektrische Verbindung zwischen dem elektrischen Eingang 125 und dem elektrischen Ausgang 130 zu schalten.

Durch die Schaltung des Erkennungsabschnitts 135 im Zusammenspiel mit dem Begrenzungsabschnitt 140 der Vorrichtung sowie die beschriebene Ansteuerung des Halbleiterschalters T109 kann das Auftreten einer Spannungsspitze von beispielsweise über 18 V oder 47 V erkannt werden und es wird in diesem Fall der Halbleiterschalter T109 über seinen Gate-Anschluss so angesteuert, dass die zu schützende Schaltung am elektrischen Ausgang 130 der Vorrichtung 100 von der Eingangsspannung am elektrischen Eingang 125 getrennt wird. Zugleich sorgt der Begrenzungsabschnitt in diesem Fall dafür, dass die Ansteuerungsspannung begrenzt wird und dass auch der Strom über eine Stromsenke begrenzt wird. Auf diese Weise wird der Halbleiterschalter T109 vor einer Beschädigung durch die Spannungsspitze geschützt.

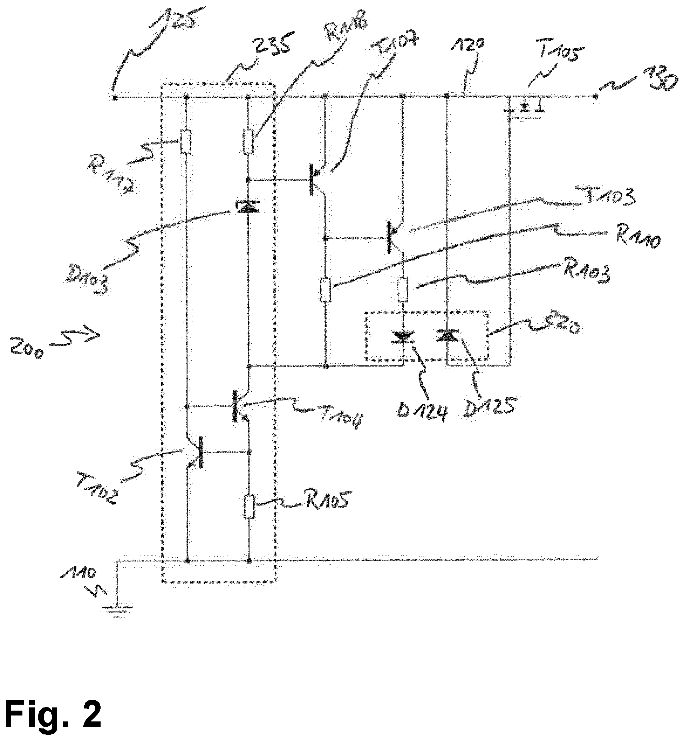

Mit Bezug zu Fig. 2 wird ein schematisches Diagramm eines zweiten Ausführungsbeispiels der Vorrichtung mit einem N-Kanal-Feldeffekttransistor erläutert. Wo der Aufbau analog zu dem ersten Ausführungsbeispiel ist, wird von den Erläuterungen oben mit Bezug zu Fig. 1 ausgegangen und die Elemente werden nicht erneut im Detail beschrieben. Es werden ferner die gleichen Bezugszeichen verwendet, wo funktionell und/oder strukturell vergleichbare Elemente verwendet werden, dies soll nicht implizieren, dass es sich notwendigerweise um die gleichen Bauteile wie bei dem ersten Ausführungsbeispiel handelt.

Auch bei der Vorrichtung 200 gemäß dem zweiten Ausführungsbeispiel sind ein elektrischer Eingang 125 und ein elektrischer Ausgang 130 vorgesehen, zwischen denen ein Halbleiterschalter T105 angeordnet ist.

Bei dem zweiten Ausführungsbeispiel ist der Halbleiterschalter T105 als N-Kanal-FET T105 ausgebildet. Auch dieser Schalter ist so angeordnet, dass durch ihn der Stromfluss zu der an den elektrischen Ausgang 130 angeschlossenen Schaltung geöffnet oder geschlossen werden kann.

Zum Herstellen der Verbindung ist allerdings eine gegenüber dem Source-Anschluss positive Ansteuerungsspannung am Gate-Anschluss des Halbleiterschalters T105 notwendig. Um diese bereitstellen zu können ist bei dem zweiten Ausführungsbeispiel eine andere Ansteuerung vorgesehen.

Es ist ein Optokoppler 145 vorgesehen, der als galvanisches Trennelement 145 fungiert und eine Leuchtdiode D124 umfasst, die in Durchlassrichtung zwischen der Verbindungsleitung 120 und der ersten Zener-Diode D103 eines Erkennungs- und Begrenzungsabschnitts 235 angeordnet ist. Der Optokoppler 145 weist ferner eine Solarzelle D125 auf, die in Durchlassrichtung in einer Ansteuerungsleitung 245 zwischen der Verbindungsleitung 120 und dem Gate-Anschluss des Halbleiterschalters T105 angeordnet ist.

Beim Erreichen oder Überschreiten des Schwellenwerts von beispielsweise 17 V oder 47 V durch die Eingangsspannung am elektrischen Eingang 125 stellt der Optokoppler 245 keine Ansteuerungsspannung für den Halbleiterschalter T105 mehr bereit, sodass der Halbleiterschalter T105 die Verbindung zu der zu schützenden Schaltung am elektrischen Ausgang 130 unterbricht.

Bei diesem Ausführungsbeispiel wird die Ansteuerungsspannung dadurch begrenzt, dass der Strom über den Erkennungs- und Begrenzungsabschnitt 235 begrenzt wird. Insbesondere ist der Optokoppler 220 das Bauteil, welches die Begrenzung der Ansteuerspannung des Halbleiterschalter T105 sicherstellt.

In anderen Worten wird bei der Erfindung eine Vorrichtung 100 mit einer Schutzschaltung bereitgestellt, welche im Wesentlichen aus zwei Teilen besteht: Ein erster Teil (Erkennungsabschnitt 135) der Schutzschaltung erkennt das Auftreten einer Überspannung ab einer gewissen Höhe und wirkt dann auf den zweiten Teil (Begrenzungsteil 140) der Schaltung ein. Der zweite Teil, zudem in diesem Fall auch eine Halbleiterschalter gezählt wird, wirkt als eine Art "Ventil", welches in der Versorgungsleitung des zu schützenden Geräts eingefügt ist. Dieses Ventil unterbricht durch die Einwirkung des ersten Teils die elektrische Verbindung zur zu schützenden Schaltung. Dadurch wirkt die Überspannung nicht auf die zu schützende Schaltung ein. Die auftretende Überspannung muss daher vollständig von dem Ventil getragen werden, ohne einen Stromfluss zu ermöglichen beziehungsweise ohne dass das Ventil selbst Schaden nimmt. Das Ventil kann insbesondere als Feldeffekt-Transistor ausgeführt sein.

Durch geeignete Dimensionierung kann die vorgeschlagene Schutzschaltung einem praktisch unbegrenzt langen Überspannungsereignis widerstehen. Auf diese Weise werden Schäden im Falle einer Fehlfunktion begrenzt, indem die geschützte Schaltung so lange wie nötig von der Energiezuleitung getrennt wird.

### Bezugszeichenliste

- 100: Vorrichtung
- 110: Anschluss (Erde)
- 120: Verbindungsleitung
- 125: elektrischer Eingang
- 130: elektrischer Ausgang
- 135: Erkennungsabschnitt
- 140: Begrenzungsabschnitt
- 145: Ansteuerungsleitung
- R103: Widerstand
- R105: Widerstand
- R110: Widerstand
- R117: Widerstand
- R118: Widerstand
- T101: Transistor
- T102: Transistor
- T103: Transistor
- T104: Transistor
- T107: Transistor
- T109: Halbleiterschalter, P-Kanal-FET
- D103: Spannungsschwellen-Detektorelement, Diode, Zener-Diode
- D104: Diode, Zener-Diode

- 200: Vorrichtung
- 220: galvanisches Trennelement, Optokoppler
- 235: Erkennungs- und Begrenzungsabschnitt
- 245: Ansteuerungsleitung
- T105: Halbleiterschalter, N-Kanal-FET
- D124: Diode, Leuchtdiode (Optokoppler)
- D125: Diode, Solarzelle (Optokoppler)

## Patentansprüche

1. Vorrichtung (100) zum Schutz einer an ein Stromversorgungsnetz, insbesondere an ein Stromversorgungsnetz eines Fahrzeugs, angeschlossenen Schaltung vor Überspannungen; umfassend
einen elektrischen Eingang (125) zum Anlegen einer Eingangsspannung;
einen elektrischen Ausgang (130) zum Bereitstellen einer elektrischen Ausgangsspannung an das Stromversorgungsnetz beziehungsweise an die angeschlossene Schaltung; und
eine elektrische Schutzschaltung mit einem Erkennungsabschnitt (135), einem Halbleiterschalter (T109) und einem Begrenzungsabschnitt (140); wobei
der Halbleiterschalter (T109) zwischen dem elektrischen Eingang (125) und dem elektrischen Ausgang (130) angeordnet und so ansteuerbar ist, dass das Ausgeben der Ausgangsspannung am elektrischen Ausgang (130) unterbrochen werden kann; wobei
der Erkennungsabschnitt (135) dazu eingerichtet ist, beim Erreichen eines Schwellenwerts der Eingangsspannung den Halbleiterschalter (T109) mittels einer Ansteuerspannung so anzusteuern, dass die Ausgabe der Ausgangsspannung unterbrochen wird; wobei
der Erkennungsabschnitt (135) ein Spannungsschwellen-Detektorelement (D103) aufweist, beispielsweise eine Zenerdiode (D103); und wobei
der Begrenzungsabschnitt (140) dazu eingerichtet ist, bei unterbrochener Ausgangsspannung die Ansteuerspannung für den Halbleiterschalter (T109) zu begrenzen; wobei
der Erkennungsabschnitt (135) eine den Strom einprägende Komponente (T102, T104) zum Begrenzen eines durch das Spannungsschwellen-Detektorelement (D103) fließenden Stroms umfasst.

2. Vorrichtung (100) gemäß Anspruch 1,
**dadurch gekennzeichnet, dass**
die den Strom einprägende Komponente (T102, T104) zwei Transistoren (T102, T104) umfasst.

3. Vorrichtung (100) gemäß einem der vorhergehenden Ansprüche,
**dadurch gekennzeichnet, dass**
der Erkennungsabschnitt (135) eine Zener-Diode (D103) umfasst, die dazu eingerichtet ist, dass sie bis zum Erreichen des Schwellenwerts der Eingangsspannung gegen einen Stromfluss gesperrt ist.

4. Vorrichtung (100) gemäß einem der vorhergehenden Ansprüche,
**dadurch gekennzeichnet, dass**
der Halbleiterschalter (T109) als P-Kanal-Feldeffekttransistor (T109) ausgebildet ist.

5. Vorrichtung (100) gemäß Anspruch 3,
**dadurch gekennzeichnet, dass**
der Gate-Anschluss des Halbleiterschalters (T109) über einen Transistor (T107) mit dem Erkennungsabschnitt (135) verbunden ist und über diesen angesteuert wird.

6. Vorrichtung (100) gemäß einem der Ansprüche 1 bis 3,
**dadurch gekennzeichnet, dass**
der Halbleiterschalter (T105) als N-Kanal-FET (T105) ausgebildet ist.

7. Vorrichtung (200) gemäß Anspruch 6,
**dadurch gekennzeichnet, dass**
der Erkennungsabschnitt (235) so mit einem galvanischen Trennelement (220) verbunden ist, dass beim Überschreiten des Schwellenwerts der Eingangsspannung der Halbleiterschalter (T105) über das galvanische Trennelement (220) so angesteuert wird, dass die Ausgabe der Ausgangsspannung unterbrochen wird.

8. Vorrichtung (100) gemäß Anspruch 7,
**dadurch gekennzeichnet, dass**
die den Strom einprägende Komponente (T102, T104) des Erkennungsabschnitts (135) dazu ausgebildet ist, den durch das galvanische Trennelement (220) fließenden Strom zu begrenzen.

9. Vorrichtung (100) gemäß Anspruch 7 oder 8,
**dadurch gekennzeichnet, dass**
das galvanische Trennelement (220) einen Optokoppler (220) umfasst, insbesondere mit einer Solarzelle (D125).

10. Vorrichtung (100) gemäß einem der vorhergehenden Ansprüche,
**dadurch gekennzeichnet, dass**
die Vorrichtung (100) zum Schutz des Stromversorgungsnetzes bei einem Lastabwurf ausgebildet ist, insbesondere bei einer an den elektrischen Eingang angeschlossenen Lichtmaschine eines Fahrzeugs.
